**Europäisches Patentamt**

**European Patent Office**

**Office européen des brevets**

(19)

(11) Veröffentlichungsnummer : **0 437 430 B1**

(12) **EUROPÄISCHE PATENTSCHRIFT**

(45) Veröffentlichungstag der Patentschrift :
24.08.94 Patentblatt 94/34

(51) Int. Cl.$^5$ : **H01L 49/02**, B41J 2/385,
H01C 7/00

(21) Anmeldenummer : **89903085.2**

(22) Anmeldetag : **10.03.89**

(86) Internationale Anmeldenummer :
**PCT/DE89/00155**

(87) Internationale Veröffentlichungsnummer :
**WO 89/09496 05.10.89 Gazette 89/24**

(54) ELEKTRISCHES WIDERSTANDSMATERIAL FÜR ELEKTROTHERMISCHE WANDLER IN DÜNNSCHICHTTECHNIK.

(30) Priorität : **29.03.88 DE 3810667**

(43) Veröffentlichungstag der Anmeldung :
**24.07.91 Patentblatt 91/30**

(45) Bekanntmachung des Hinweises auf die Patenterteilung :
**24.08.94 Patentblatt 94/34**

(84) Benannte Vertragsstaaten :
**DE FR GB IT NL SE**

(56) Entgegenhaltungen :
US-A- 4 105 892
Thin Solid Films, Band 69, Nr. 3, Juli 1980, Elsevier Sequoia S.A. (Lausanne, CH), Y. Saito et al.: "Lifetime of heat-resistive films prepared by sputtering"

(56) Entgegenhaltungen :
PATENT ABSTRACTS OF JAPAN, Band 12, Nr. 55, (M-669) (2902), 19. Februar 1988 & JP-A-62202753
PATENT ABSTRACTS OF JAPAN, Band 7, Nr. 230, (M-249) (1375), 12. Oktober 1983 & JP-A-58122884

(73) Patentinhaber : **SIEMENS AKTIENGESELLSCHAFT**
**Wittelsbacherplatz 2**
**D-80333 München (DE)**

(72) Erfinder : **PÖTZLBERGER, Hans Werner**
**Steinstrasse 8**
**W-8000 München 80 (DE)**
Erfinder : **KASTNER, Konrad**
**Michael-Wening-Strasse 5**
**W-8018 Grafing (DE)**
Erfinder : **HÖSSELBARTH, Birgitta**
**Pfälzer Strasse 32**
**W-8201 Grosskarolinenfeld (DE)**

EP 0 437 430 B1

**Beschreibung**

Die Erfindung betrifft elektrisches Widerstandsmaterial für elektrothermische Wandler in Dünnschichttechnik, insbesondere für die Druckköpfe von Thermodruckern, enthaltend hochschmelzende Übergangsmetall/Nichtmetallverbindungen, sowie ein Verfahren zu ihrer Herstellung.

Elektrothermische Wandler oder auch Thermowandler nutzen die bei der elektrischen Belastung eines Leiters entstehende Joule'sche Wärme zur Erzeugung von örtlich und zeitlich genau definierter Wärme. Thermowandler sind schnell ansprechbar, gut zu steuern und können daher überall dort Anwendung finden, wo relativ geringe Heizleistung erforderlich ist. Weitverbreitet ist die Anwendung des Thermowandlerprinzips bei verschiedenen Druckverfahren, zum Beispiel Thermodruckverfahren oder dem Tintenstrahldruckverfahren "Bubble-Jet". Bei diesen Verfahren werden die zu druckenden Zeichen aufgerastert und aus mehreren sogenannten Dots zusammengesetzt, wobei diese Dots aus Thermowandlern bestehen. Bei elektrischer Ansteuerung eines solchen Dots wird dieser von Strom durchflossen und erwärmt sich dadurch. Diese selektive Erwärmung wird für den Druckvorgang ausgenutzt. Bei einem wärmeempfindlichen Papier wird die Farbe direkt auf bzw. in dem Papier erzeugt. Auch ist es möglich, ein wärmeempfindliches Farbband zu verwenden, bei dem durch die lokale Erwärmung eine Wachsschicht aufgeschmolzen und auf das Papier übertragen wird, und wobei ein Farbstoff in der Wachsschicht enthalten ist. Beim Bubble-Jet-Druckverfahren wird ein Bestandteil der Tinte durch Wärmezufuhr verdampft. Die dabei entstehenden Gasblasen bewirken eine Übertragung der Tinte auf das zu bedruckende Medium.

Um eine ansprechende Druckgeschwindigkeit des Thermodruckkopfes zu erzielen, müssen an das Widerstandsmaterial extreme thermische und elektrische Anforderungen gestellt werden. Ständige Temperaturwechsel und eine hohe Frequenz der "Heizstrom-Impulse" führen sowohl zu frühzeitiger mechanischer Ermüdung des Materials, als auch zu einer Verschlechterung der elektrischen Werte.

Ein brauchbares Widerstandsmaterial für Thermowandler in Thermodruckköpfen muß einen hohen spezfischen Widerstand aufweisen. Da die Ansteuerung des Thermowandlers über eine integrierte Schaltung erfolgt, muß die Stromstärke begrenzt werden, um den Schaltkreis (IC) nicht zu überlasten. Außerdem muß das Widerstandsmaterial über die ganze Lebensdauer des Thermowandlers einen nahezu konstanten Widerstand aufweisen, da die Spannung in der integrierten Schaltung konstant ist und sich sonst ein großer Effekt auf die Druckqualität des Thermodruckers ergeben würde. Weitere Anforderungen werden an die Verarbeitbarkeit der Widerstandsmaterialien gestellt. Diese müssen in Dünnfilmtechnik auszuführen sein und mit den anderen Verfahren bzw. Materialien zum Aufbau des Thermowandlerelements kompatibel sein.

Bekannt sind Widerstandsmaterialen auf der Basis der Nitride, Boride und Silizide von Tantal, Zirkon, Hafnium, Chrom und andere Zweistoffsysteme. Diese weisen einen spezifischen elektrischen Widerstand zwischen 250 und 400 $\mu \Omega$ cm auf. Um bei diesem Widerstandswert eine ausreichende Heizleistung zu erzielen, können die Dots bzw. Thermowandlerelemente nicht flächig ausgeführt werden. Die zu erhitzende Fläche wird von mäanderförmigen Strukturen aus Widerstandsmaterial angenähert, um einen niedrigeren Leiterbahnquerschnitt und somit einen höheren Flächenwiderstand zu erzielen.

Nakamori et al stellen auf einem Beitrag zu IEEE Transaction on Components, Hybrids, and Manufacturing Technology, Vol. CHMT-10, Nr. 3, September 1987, Seite 446, ein neues Widerstandsmaterial für Thermowandler vor, welches aus einem Tantal/Silizium/Kohlenstoff-System besteht. Schichten aus diesem Material werden durch Sputtern erzeugt. Sie weisen zwar einen hohen Widerstandswert auf, jedoch ist dieser äußerst stark von dem Kohlenstoffgehalt der erzeugten Schicht abhängig. Auch andere Eigenschaften dieses Materials sind stark vom Kohlenstoffgehalt abhängig, der allerdings nur schwierig und nur in Verbindung mit dem Tantalgehalt einzustellen ist.

Aufgabe der vorliegenden Erfindung ist es daher, ein Widerstandsmaterial für Dünnschicht-Thermowandler anzugeben, welches einen hohen Widerstand aufweist, der auch über die gesamte Lebensdauer des Thermowandlers nahezu konstant bleibt. Dabei soll das Material einfach und reproduzierbar herzustellen sein, gut zu verarbeiten und mit den anderen Verfahrenstechniken kompatibel sein.

Diese Aufgabe wird durch ein elektrisches Widerstandsmaterial der eingangs genannten Art erfindungsgemäß dadurch gelöst, daß die durch Kathodenzerstäuben erzeugten Schichten aus vier Komponenten bestehen, wovon eine Komponente ein Metall der vierten Nebengruppe ist, eine weitere Komponente ausgewählt ist aus den Metallen der fünften und sechsten Nebengruppe und die übrigen zwei Komponenten nichtmetallische Elemente sind, ausgewählt aus der Gruppe Silizium, Bor, Kohlenstoff und Stickstoff.

Weitere Ausgestaltungen der Erfindung sind den Ansprüchen 2 bis 9 zu entnehmen.

Eine bevorzugte Ausführungsform des erfindungsgemäßen Gedankens umfaßt ein Mehrstoffsystem aus vier Komponenten. Bevorzugt enthält es ein Metall aus der vierten Nebengruppe (Titan, Zircon und Hafnium), während ein zweites und eventuell auch noch ein weiteres Metall aus der fünften und sechsten Nebengruppe (Chrom, Molybdän, Wolfram, Vanadium, Niob und Tantal) ausgewählt sind. Als Nichtmetallkomponenten sind vor allem diejenigen Hauptgruppenelemente geeignet, die mit den erwähnten Nebengruppenmetallen hochschmelzende binäre Verbindungen ergeben. Diese auch als "refractory-materials" bekannten Verbindungen sind vor allem die Boride, Silizide, Nitride und Carbide.

Erfindungsgemäß werden die Schichten durch Sputtern von Mischtargets erzeugt, wobei die Mischtargets aus zumindest zwei der binären Verbindungen hergestellt sind. Es wurde nun gefunden, daß in solchen Mehrstoffsystemen der elektrische Widerstand ganz wesentlich vom Sauerstoffgehalt und insbesondere auch vom Stickstoffgehalt der so erzeugten Schichten abhängig ist. Diese starke Abhängigkeit nutzt die Erfindung. Durch Variation des Stickstoff- bzw. Sauerstoffgehalts der so erzeugten Schichten werden erfindungsgemäß die elektrischen Eigenschaften der Schichten eingestellt.

Besonders gute bzw. hohe Widerstandswerte weisen solche Schichten auf, die zumindest 4 bis ca. 60 Atom-Prozent Stickstoff enthalten, wobei der dazugehörige Metallanteil zwischen 15 und 50 Atom-Prozent beträgt und die zu 100 Atom-Prozent fehlenden Anteile von zumindest einem der anderen erwähnten Nichtmetalle gebildet werden.

Erfindungsgemäße Schichten weisen einen hohen spezifischen Widerstand von bis zu 5000 $\mu\,\Omega$ cm auf. Nach mehrstündiger Temperung bei ca. 450°C ist nur eine unwesentliche Abnahme dieses Widerstandswerts zu beobachten. Dabei ist der größte Teil der maximal 6 Prozent des Anfangswertes betragenden Widerstandsänderung gleich zu Beginn der thermischen Belastung zu beobachten. Bei weiterer Temperung stabilisiert sich der Widerstand. Ähnlich stabil zeigt sich der Widerstand bei elektrischer Belastung in einem sogenannten stepstress-test. Allerdings ist hier eine relativ höhere Widerstandsänderung zu Beginn der Belastung festzustellen.

Diese Stabilität des Widerstands auf hohem Niveau ist ein entscheidender Vorteil der erfindungsgemäßen dünnen Schichten. Für deren Verwendung als Thermowandler in den Druckköpfen von Thermodruckern ist diese Eigenschaft unabdingbare Voraussetzung für eine gute Druckqualität. Ein weiterer Vorteil der Erfindung bzw. des Verfahrens ist die gute Reproduzierbarkeit der Schichteigenschaften.

Im folgenden wird ein Verfahren zum Herstellen von dünnen Schichten aus dem Widerstandsmaterial anhand eines Ausführungsbeispiels und zweier Figuren noch näher erläutert.

Die Figur 1 zeigt den Aufbau eines Thermodruckkopfes, während

in Figur 2 die Widerstandsänderung bei Temperung in Abhängigkeit vom Stickstoffgehalt der Schichten dargestellt ist.

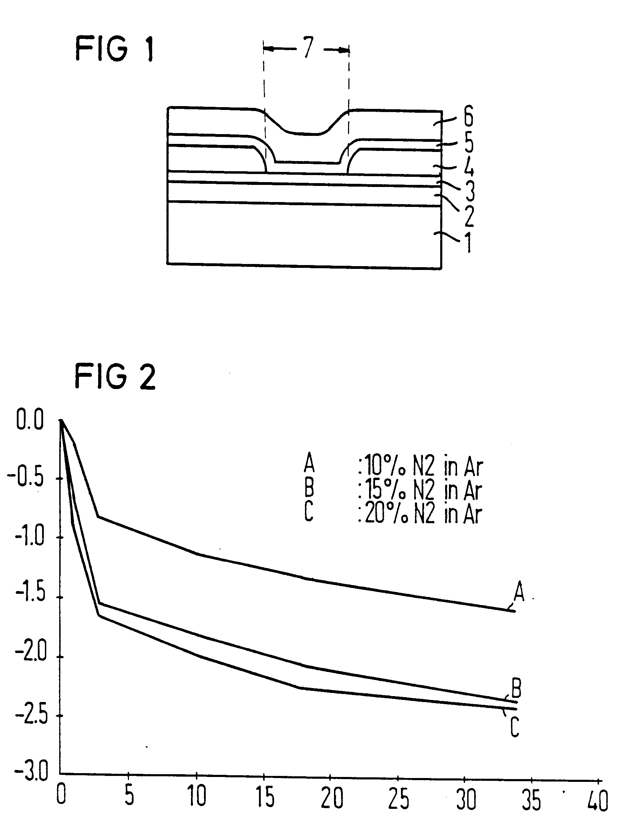

Figur 1 zeigt den bekannten Aufbau eines Thermowandlerelements in schematischem Querschnitt. Auf einem Substrat 1, welches zum Beispiel aus einer Keramik bestehen kann, ist eine Wärmeisolationsschicht 2, vorzugsweise aus Glas, aufgebracht. Mit 3 ist eine dünne Schicht aus dem Widerstandsmaterial bezeichnet, welches erfindungsgemäß zum Beispiel aus einem Vierstoffsystem bestehen kann. Darüber sind die Leiterbahnen 4 aufgebracht. Die zwischen den Leiterbahnen 4 ausgesparte und mit Widerstandsmaterial 3 unterlegte Fläche 7 stellt die eigentliche Heizzone des Thermowandlers dar. Bei bekannten Ausführungen ist das Widerstandsmaterial 3 im Bereich dieser Fläche 7 mäanderförmig strukturiert, um einen geringeren Leiterbahnquerschnitt zu erzielen. Bei Verwendung höherohmigen Widerstandsmaterials kann die Heizfläche auch ganzflächig von Widerstandsmaterial 3 bedeckt sein. Ein höherer Leiterbahnquerschnitt wird dann von dem höheren Widerstandswert des Materials ausgeglichen. Zum Schutz der Leiterbahnen 3 und 4 vor drohender Oxidation beim Betrieb des Thermowandlers, welcher zu einer enormen Temperaturerhöhung der Teile im Bereich der Fläche 7 führt, ist eine Oxidationsschutzschicht 5 vorgesehen. Abschließend ist noch eine Abriebschutzschicht 6 aufgebracht, die in einigen Ausführungen mit der Schicht 5 zusammen eine Einheit bilden und zum Beispiel aus gesputtertem Siliziumdioxid bestehen kann.

Ausführungsbeispiel:

Zur Erprobung der erfindungsgemäßen Schichten werden Testwafer verwendet, mit dünnen Schichten des erfindungsgemäßen Widerstandsmaterials versehen und anschließend in an sich bekannter Weise zu Thermowandlern (ähnlich wie in Figur 1 dargestellt) weiterverarbeitet. Als Teststruktur wird ein Thermokamm gewählt (= besondere Form eines Thermodruckkopfes).

Das Substrat 1 für die Thermowandlerstrukturen ist ein Siliziumwafer, auf dem zur elektrischen Isolation 2 eine ca. 2 $\mu$m starke thermische Oxidschicht erzeugt wird. In einer Magnetronsputteranlage (MRC 903-Aufstäubanlage) wird nun eine dünne Schicht elektrischen Widerstandsmaterials 3 von zum Beispiel 70 nm Dicke erzeugt. Doch ist die erforderliche Schichtdicke vom elektrischen Widerstand der Schicht abhängig und kann zwischen 10 und 125 nm betragen. Dabei dienen gesinterte Mischungen von Titansilizid (10 Gewichtsprozent) und Wolframsilizid (90 Gewichtsprozent) als Target. Doch sind auch viele andere Mischungen als Targets einsetzbar (zum Beispiel $TiB_2/WSi_2$, $ZrB_2/WSi_2$ und viele andere mehr). Folgende Sputterbedingungen werden eingestellt:

DC-Betrieb mit 0,5 - 1 KW

Aufstäubzeit ca. 2 Minuten

Sputtergas Argon mit variierenden Stickstoffanteilen

Mit Hilfe des Stickstoffanteils in der Sputteratmosphäre wird die Zusammensetzung und damit der spezifische elektrische Widerstand der zu erzeugenden Schicht beeinflußt. Eine ähnliche Wirkung kann durch alternative oder zusätzliche Zugabe von Sauerstoff erzielt werden. In der Tabelle sind die Zusammensetzungen derart erzeugter Schichten in Abhängigkeit vom Stickstoffanteil in der Sputteratmosphäre angegeben.

| Probe Nr. | $N_2$-Anteil Vol.-% in Ar | Gewichtsanteile in % [a] | | | |
|---|---|---|---|---|---|
| | | Ti [b] | W [c] | Si [d] | N [e] |
| 1 | 0,3 | 4,0 | 73,3 | 21,8 | 0,9 |
| 2 | 2 | 3,7 | 72,7 | 21,5 | 2,1 |
| 3 | 5 | 3,7 | 71,0 | 21,3 | 4,0 |
| 4 | 10 | 3,3 | 69,2 | 20,9 | 6,6 |
| 5 | 15 | 3,0 | 67,9 | 20,6 | 8,5 |
| 6 [f] | 20 | 2,6 | 65,0 | 20,5 | 11,9 |

a) auf 100 % normiert;

b) Genauigkeit $\pm$ 0,2 %;

c) Genauigkeit $\pm$ 0,7 %;

d) Genauigkeit $\pm$ 0,3 %;

e) Genauigkeit $\pm$ 0,4 %;

f) gemessen bei höherem Gesamtgasstrom.

Die Wafer werden anschließend in an sich bekannter Weise strukturiert, mit Leiterbahnen 3 versehen und schließlich mit einer $SiO_2$-Schutzschicht (5, 6) abgedeckt.

An den so fertiggestellten Thermowandlerelementen werden anschließend die Schaltungs- und Flächenwiderstände gemessen und der spezifische Widerstand bestimmt, der im Bereich zwischen 400 $\mu\,\Omega$ cm und 5000 $\mu\,\Omega$ cm liegt. Die Höhe des Widerstands steigt mit wachsendem Stickstoffgehalt der widerstandsschicht. In einer weiteren Messung wird die Widerstandsänderung nach Temperaturbelastung bestimmt.

Figur 2 gibt die Widerstandsänderung von 3 Schichten wieder, die mit unterschiedlichen Stickstoffgehalten in der Sputteratmosphäre erzeugt wurden. Die Änderung ist dabei in Prozent relativ zum Anfangswert (nach der Strukturierung) angegeben und gegen die Dauer der Temperung (bei 450°C) in Stunden aufgetragen. Wie leicht zu erkennen ist, fällt der Widerstand zunächst relativ stark ab und nähert sich danach einem konstanten Wert an. Diese Langzeitstabilität ist neben der absoluten Höhe des Widerstands ein entscheidender Vorteil der erfindungsgemäß erzeugten Schichten. Durch eine kurzzeitige Vortemperung der Schichten kann also sofort Langzeitstabilität des elektrischen Widerstands der Schichten erreicht werden.

**Patentansprüche**

1. Elektrisches Widerstandsmaterial für elektrothermische Wandler in Dünnschichttechnik, insbesondere für Druckköpfe von Thermodruckern, enthaltend hochschmelzende Übergangsmetall/Nichtmetallverbindungen, **dadurch gekennzeichnet,** daß die durch Kathodenzerstäuben erzeugten Schichten aus vier Komponenten bestehen, wovon eine Komponente ein Metall der vierten Nebengruppe ist, eine weitere Komponente ausgewählt ist aus den Metallen der fünften und sechsten Nebengruppe und die übrigen zwei Komponenten nichtmetallische Elemente sind, ausgewählt aus der Gruppe Silizium, Bor, Kohlenstoff und Stickstoff.

2. Elektrisches Widerstandsmaterial für elektrothermische Wandler in Dünnschichttechnik, insbesondere für Druckköpfe von Thermodruckern, enthaltend hochschmelzende Übergangsmetall/Nichtmetallverbindungen, **dadurch gekennzeichnet,** daß die durch Kathodenzerstäuben erzeugten Schichten aus fünf Komponenten bestehen, wovon zwei Komponenten die Metalle Titan und Wolfram oder Zirkon und Wolfram sind und die übrigen Komponenten die Nichtmetalle Silizium, Bor und Stickstoff sind.

3. Widerstandsmaterial nach Anspruch 1 oder 2, **dadurch gekennzeichnet,** daß es 4 bis 60 Atom-Prozent Stickstoff enthält und daß der Metallanteil zwischen 15 und 50 Atom-Prozent beträgt.

4. Verfahren zum Herstellen der Widerstandsmaterialschichten nach Anspruch 1 bis 4, **dadurch gekennzeichnet,** daß zumindest die Metallkomponenten durch Sputtern von die Metallkomponenten enthaltenden Targets auf einem Träger abgeschieden werden und zumindest eine der Nichtmetallkomponenten in Form eines dieses Nichtmetall enthaltenden Gases der Sputteratmosphäre beigefügt wird.

5. Verfahren nach Anspruch 4, **dadurch gekennzeichnet,** daß der Sputteratomosphäre Stickstoff beigemengt wird.

6. Verfahren nach Anspruch 4, **dadurch gekennzeichnet,** daß der Sputteratmosphäre Sauerstoff beigemengt wird.

7. Verfahren nach mindestens einem der Ansprüche 4 bis 6, **dadurch gekennzeichnet,** daß zum Sputtern gesinterte Mischtargets verwendet werden, welche aus mindestens zwei Übergangsmetallverbindungen der Gruppe der Silizide, Boride, Carbide und Nitride hergestellt sind.

8. Verfahren nach Anspruch 7, **dadurch gekennzeichnet,** daß ein Mischtarget aus Titansilizid/Wolframsilizid verwendet wird.

9. Verfahren nach Anspruch 4, 5 und 8, **dadurch gekennzeichnet,** daß ein Mischtarget verwendet wird, das zu 90 Gewichtsprozent aus Wolframsilizid und zu 10 Gewichtsprozent aus Titansilizid besteht.

## Claims

1. Electrical resistance material for electrothermal transducers in thin-layer technology, in particular for print heads of thermal printers, containing high-melting transition metal/nonmetal compounds, characterized in that the layers generated by means of cathode sputtering consist of four components, one component of which is a metal of the fourth additional group, a further component is selected from the metals of the fifth and sixth additional group and the remaining two components are non-metallic elements, selected from the group silicon, boron, carbon and nitrogen.

2. Electrical resistance material for electrothermal transducers in thin-layer technology, in particular for print heads of thermal printers, containing high-melting transition metal/nonmetal compounds, characterized in that the layers generated by means of cathode sputtering consist of five components, two components of which are the metals titanium and tungsten or zirkon and tungsten and the remaining components are the nonmetals silicon, boron and nitrogen.

3. Resistance material according to claim 1 or 2, characterized in that it contains 4 to 60 % by atom nitrogen and in that the metal portion amounts to between 15 and 50 % by atom.

4. Method for producing the resistance-material layers according to claims 1 to 4, characterized in that at least the metal components are separated by sputtering from targets containing the metal components on a carrier and at least one of the nonmetal components is added to the sputter atmosphere in the form of a gas containing this nonmetal.

5. Method according to claim 4, characterized in that nitrogen is added to the sputter atmosphere.

6. Method according to claim 4, characterized in that oxygen is added to the sputter atmosphere.

7. Method according to at least one of claims 4 to 6, characterized in that sintered mixing targets are used for the sputtering, being produced from at least two transition metal compounds of the group of silicides, borides, carbides and nitrides.

**8.** Method according to claim 7, characterized in that a mixing target of titanium silicide/tungsten silicide is used.

**9.** Method according to claims 4, 5 and 8, characterized in that a mixing target is used, 90 % by weight of which is tungsten silicide and 10 % by weight of which is titanium silicide.

## Revendications

**1.** Matériau électro-résistif pour transducteurs électrothermiques, réalisé selon la technique des couches minces, notamment pour des têtes d'impression d'imprimantes thermiques, contenant des composés métal de transition/ élément non métallique à point de fusion élevé, caractérisé par le fait que les couches formées par pulvérisation cathodique sont constituées de quatre constituants, dont l'un est un métal du quatrième groupe auxiliaire, un autre constituant est sélectionné parmi les métaux des cinquième et sixième groupes auxiliaires et les deux autres constituants sont des éléments non métalliques, choisis dans le groupe comprenant le silicium, le bore, le carbone et l'azote.

**2.** Matériau électro-résistif pour convertisseur électrothermique, réalisé selon la technique des couches minces, notamment pour des têtes d'impression d'imprimantes thermiques, contenant des composés métal de transition/ élément non métallique à haut point de fusion, caractérisé par le fait que les couches, produites par pulvérisation cathodique, sont constituées de cinq constituants, dont deux sont les métaux titane et tungstène ou zirconium et tungstène, et les autres constituants sont les éléments non métalliques silicium, bore et azote.

**3.** Matériau résistif suivant la revendication 1 ou 2, caractérisé par le fait qu'il contient de l'azote en un pourcentage atomique de 4 à 60 et que la partie métallique représente un pourcentage atomique compris entre 15 et 50.

**4.** Procédé de préparation des couches de matériau résistif suivant les revendications 1 à 4, caractérisé en ce qu'on dépose tout d'abord les constituants métalliques, par pulvérisation cathodique de cibles contenant les constituants métalliques, sur un support et qu'on ajoute au moins l'un des constituants non métalliques sous la forme d'un gaz de l'atmosphère de pulvérisation, ce gaz renfermant cet élément non métallique.

**5.** Procédé selon la revendication 4, caractérisé en ce qu'on ajoute de l'azote à l'atmosphère de pulvérisation.

**6.** Procédé selon la revendication 4, caractérisé en ce qu'on ajoute de l'oxygène à l'atmosphère de pulvérisation.

**7.** Procédé selon au moins l'une des revendications 4 à 6, caractérisé en ce que pour la pulvérisation cathodique on utilise des cibles mixtes frittées, qui sont fabriquées à partir d'au moins deux composés d'un métal de transition du groupe des siliciures, des borures, des carbures et des nitrures.

**8.** Procédé selon la revendication 7, caractérisé en ce qu'on utilise une cible mixte formée de siliciure de titane/siliciure de tungstène.

**9.** Procédé selon les revendications 4, 5 et 8, caractérisé en ce qu'on utilise une cible mixte, qui est constituée pour 90 pour cent en poids de siliciure de tungstène et pour 10 pour cent en poids de siliciure de titane.

## FIG 1

## FIG 2

A    :10% N2 in Ar
B    :15% N2 in Ar
C    :20% N2 in Ar